# EUROPÄISCHE PATENTSCHRIFT

(11) **EP 0 896 431 B1**
(45) Veröffentlichungstag und Bekanntmachung des Hinweises auf die Patenterteilung: **24.09.2003**
(21) Anmeldenummer: 98114224.3
(22) Anmeldetag: 29.07.1998
(51) Int. Cl.: H03K 5/1252

(54) **Verfahren und Schaltungsanordnung zur Bearbeitung digitaler Signale**
Circuit for processing digital signals and method therefor
Circuit de traitement de signaux numériques et procédé

(30) Priorität: 04.08.1997 DE 19733733
(43) Veröffentlichungstag der Anmeldung: 10.02.1999
(73) Patentinhaber: Infineon Technologies AG, 81669 München (DE)
(72) Erfinder: Buck, Martin, 81243 München (DE)
(74) Vertreter: Fischer, Volker, Dipl.-Ing.

(56) Entgegenhaltungen:
- EP-A- 0 009 549
- EP-A- 0 320 711
- DE-A- 3 133 667
- US-A- 3 970 944
- US-A- 4 471 235
- US-A- 5 418 486

## Beschreibung

Die Erfindung betrifft ein Verfahren zur Bearbeitung digitaler Signale, wie beispielsweise Taktsignale. Die Erfindung betrifft außerdem eine Schaltungsanordnung zur Durchführung des Verfahrens.

Häufig werden bei der Verarbeitung digitaler Signale nur die Flanken ausgewertet. Unter einer Flanke versteht man einen Wechsel eines logischen Zustandes zu einem anderen logischen Zustand. Die Änderung eines Signals von einer logischen Null zu einer logischen Eins wird als steigende Flanke bezeichnet, die Änderung von einer logischen Eins zu einer logischen Null als fallende Flanke.

Zwar weisen digitale Signale gegenüber analogen Signalen einen höheren Signalstörabstand auf, dennoch können überlagertes Rauschen, durch Kopplung verursachte Spannungseinbrüche oder Einschwingvorgänge nach den Flanken zu einer fehlerhaften Auswertung des Signalinhaltes führen.

Es sind Schaltungen bekannt, die nach Auftreten einer steigenden Flanke den folgenden Signalanteil für eine gewisse Zeitspanne unberücksichtigt lassen. In dieser Zeitspanne auftretende Störungen mit einem signalähnlichen Pegel werden nicht als Nutzsignal gewertet. Die Zeitspanne ist dabei kleiner als die Zeitspanne zwischen zwei aufeinander folgenden steigenden Flanken eines störungsfreien Signals. Sie muß so kurz sein wie es die maximale Taktrate erfordert.

Nachteil dieser Schaltungen ist, dass die Zeitspanne, in der der Signalanteil unberücksichtigt bleibt, konstant ist und so bemessen sein muss, dass auch bei hohen Taktraten, also geringen zeitlichen Abständen zwischen zwei Flanken, ein Nutzsignal sicher erkannt wird. Das heißt aber, dass bei kleineren als der maximalen Taktrate diese Zeitspanne wesentlich kleiner ist als der zeitliche Abstand zwischen zwei Flanken. Die Störunanfälligkeit ist also in starkem Maß von der Taktrate abhängig. Sie ist am größten bei der maximalen Taktrate.

Die Aufgabe der Erfindung besteht darin, ein Verfahren zur Bearbeitung digitaler Signale sowie eine Schaltungsanordnung zur Durchführung des Verfahrens anzugeben mit hoher, gleichbleibender Sicherheit gegen Störsignale bei verschiedenen Taktraten des digitalen Signals.

Erfindungsgemäß wird diese Aufgabe durch die Merkmale des Patentanspruchs 1 gelöst. Eine Schaltungsanordnung zur Durchführung des Verfahrens ist im Patentanspruch 6 angegeben.

Das erfindungsgemäße Verfahren eignet sich bei digitalen Signalen, bei denen nur eine Flanke, beispielsweise die steigende Flanke, zur Auswertung herangezogen wird.

Das erfindungsgemäße Verfahren hat den Vorteil, dass die Störsicherheit nicht von der Taktrate des digitalen Signals abhängt. Zudem kann es sowohl bei periodischen als auch bei nichtperiodischen digitalen Signalen eingesetzt werden.

Ausgestaltungen der Erfindung sind in den Unteransprüchen gekennzeichnet.

Die Erfindung wird anhand der in der Zeichnung dargestellten Figuren nachfolgend erläutert. Es zeigen:
Figur 1 ein Signaldiagramm zur Erläuterung des erfindungsgemäßen Verfahrens;
Figur 2 ein Blockschaltbild der erfindungsgemäßen Schaltungsanordnung;
Figur 3 eine Ausführungsform einer Aktivierungsschaltung;
Figur 4 eine Ausführungsform einer Ausgangsschaltung und
Figur 5 eine Ausführungsform eines Pulsgenerators.

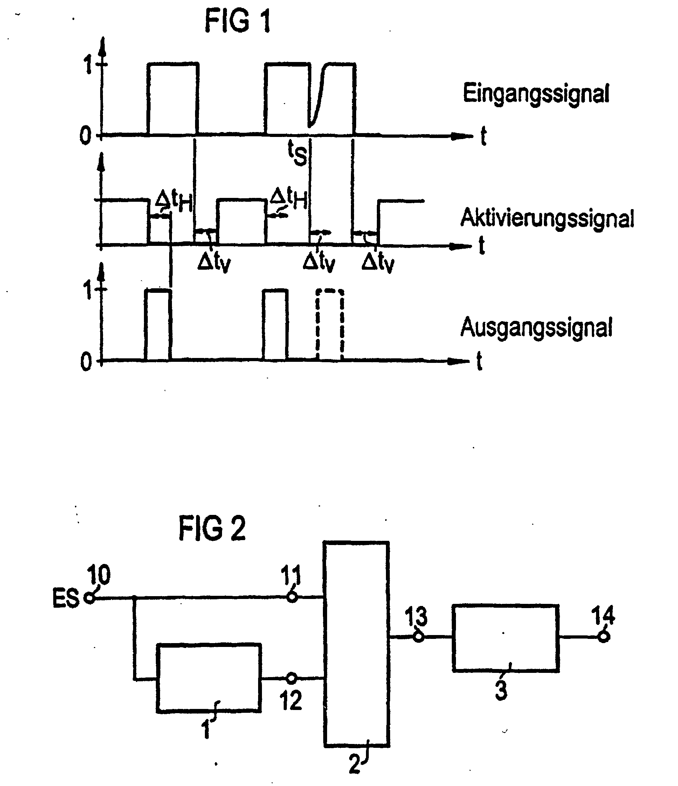

In dem Signaldiagramm nach Figur 1 sind ein digitales Eingangssignal ES, ein Aktivierungssignal AKS und ein digitales Ausgangssignal AS über der Zeit t aufgetragen. Tritt im zeitlichen Verlauf des Eingangssignales ES eine steigende Flanke auf, so wechselt das Aktivierungssignal AKS von einem Aktivzustand zu einem Passivzustand. Nur wenn das Aktivierungssignal AKS im Aktivzustand ist, können Änderungen des Eingangssignals ES vom Ausgangssignal AS übernommen werden. Während des Passivzustandes des Aktivierungssignals AKS bleiben Änderungen des Eingangssignals ES wirkungslos für das Ausgangssignal AS. Da nach Figur 1 zum Zeitpunkt des Auftretens der steigenden Flanke das Aktivierungssignal AKS noch im Aktivzustand ist, übernimmt das Ausgangssignal AS die steigende Flanke.

Folgt der steigenden Flanke des Eingangssignals ES eine fallende Flanke, so verharrt das Aktivierungssignal AKS für eine Verzugszeit Δt_{V} noch im Passivzustand, bevor es wieder in den Aktivzustand zurückkehrt. Der Aktivzustand wird also nach einer fallenden Flanke des Eingangssignals ES um die Verzugszeit Δt_{V}, die ab dem Zeitpunkt des Auftretens der fallenden Flanke des Eingangssignals ES läuft, verzögert erreicht. Der Zeitpunkt, zu dem die Verzugszeit Δt_{V} zu laufen beginnt, kann frühestens eine Haltezeit Δt_{H} nach dem Zeitpunkt des Auftretens der steigenden Flanke des Eingangssignals ES liegen. Die Dauer des Passivzustandes beträgt somit minimal die Summe aus Verzugszeit Δt_{V} und Haltezeit Δt_{H}.

Wenn das Eingangssignal ES von der logischen Eins zum logischen Zustand Null wechselt, geht nach der Verzugszeit Δt_{V} das Aktivierungssignal AKS in den Aktivzustand. Das Ausgangssignal AS übernimmt daraufhin die logische Null des Eingangssignals ES.

Wird das Eingangssignal ES, während es sich im logischen Zustand Eins befindet, von einer Störung überlagert, die als fallende Flanke gewertet wird, so nimmt das Aktivierungssignal AKS nur den Aktivzustand an, wenn sich das Eingangssignal ES nach Ablauf der Verzugszeit Δt_{V} im logischen Zustand Null befindet. Störungen, deren zeitliches Auftreten kürzer ist als die Verzugszeit Δtᵥ, werden also als solche erkannt.

Die Werte für die Verzugszeit Δtᵥ und die Haltezeit Δt_{H} sind empirisch zu ermitteln. Die Verzugszeit Δt_{V} muss dabei kleiner sein, als die kleinste auftretende Dauer einer logischen Null, die Haltezeit Δt_{H} muss kleiner als die kleinste auftretende Dauer einer logischen Eins des Eingangssignals ES sein.

Das Ausgangssignal AS bleibt nach der steigenden Flanke beispielsweise für eine bestimmte Zeit konstanter Dauer auf dem logischen Zustand Eins, so dass ein pulsförmiges Ausgangssignal AS entsteht. Es ist jedoch auch möglich, dass es erst dann wieder den logischen Zustand Null annimmt, wenn das Eingangssignal ES den logischen Zustand Null angenommen hat und das Aktivierungssignal AKS im Aktivzustand ist.

Im Signaldiagramm nach Figur 1 ist als Aktivzustand der logische Zustand Eins und als Passivzustand der logische Zustand Null eingetragen. Das Ausgangssignal AS hat hier pulsförmigen Charakter. Der gestrichelt eingetragene Impuls des Ausgangssignals AS würde sich ergeben, wenn das Eingangssignals ES zum Zeitpunkt tₛ von einem Störsignal überlagert wird und das erfindungsgemäße Verfahren nicht angewendet wird.

Das Signaldiagramm nach Figur 1 zeigt ein nichtperiodisches Eingangssignal ES. Das erfindungsgemäße Verfahren arbeitet ebenso bei periodischen Eingangssignalen ES mit beliebigem Taktverhältnis. Für den Fachmann ist es offensichtlich, dass das erfindungsgemäße Verfahren auch mit invertiertem Signal arbeitet. Der Passivzustand des Aktivierungssignals AKS kann beispielsweise auch auf eine fallende Flanke des . Eingangssignals ES folgen. Der Aktivzustand stellt sich dann nach der Verzugszeit Δt_{V} auf eine steigende Flanke des Eingangssignals ES ein.

In Figur 2 ist ein Blockschaltbild einer möglichen Schaltungsanordnung zur Durchführung des erfindungsgemäßen Verfahrens dargestellt. An einem Eingang 10 der Schaltungsanordnung ist das Eingangssignal ES einer Aktivierungsschaltung 1 und einer Ausgangsschaltung 2 zuführbar. Der Ausgang der Aktivierungsschaltung 1 ist mit einem Eingang 12 der Ausgangsschaltung 2 verbunden. Am Ausgang 13 der Ausgangsschaltung 2 ist das Ausgangssignal AS entnehmbar.

In einer weiteren Ausführungsform der Schaltungsanordnung ist der Ausgangsschaltung 2 ein Pulsgenerator 3 nachgeschaltet. Bei dieser Ausführungsform entspricht der Ausgang 14 des Pulsgenerators 3 dem Ausgang der Schaltungsanordnung.

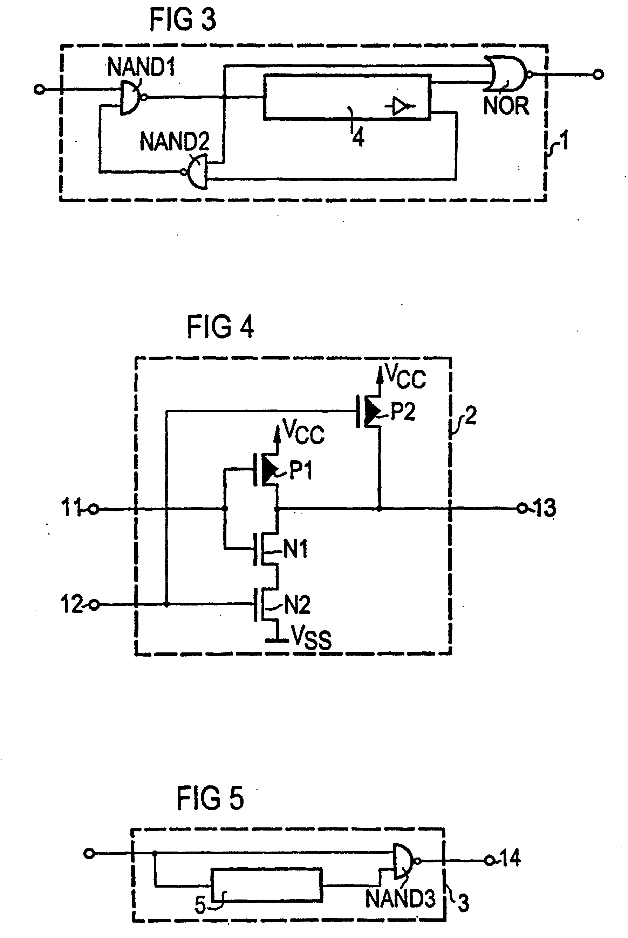

Eine mögliche Ausführungsform der Aktivierungsschaltung 1 ist in Figur 3 dargestellt. Demnach schließt die Aktivierungsschaltung 1 eine Verzögerungseinrichtung 4 ein, deren Eingang mit dem Ausgang eines ersten NAND-Gatters NAND1, einem Eingang eines zweiten NAND-Gatters NAND2 und einem Eingang des NOR-Gatters NOR verbunden ist. Die Verzögerungseinrichtung 4 weist neben dem Eingang einen nichtinvertierenden und einen invertierenden Ausgang auf. Der nichtinvertierende Ausgang ist mit einem weiteren Eingang des NOR-Gatters NOR, der invertierende Ausgang ist mit einem weiteren Eingang des zweiten NAND-Gatters NAND2 verbunden.

Der Ausgang des NOR-Gatters NOR entspricht dem Ausgang der Aktivierungsschaltung 1. Der Eingang der Aktivierungsschaltung 1, der dem Eingang 10 der Schaltungsanordnung entspricht, ist an einen ersten Eingang des ersten NAND-Gatters NAND1 angeschlossen. Ein weiterer Eingang des ersten NAND-Gatters NAND1 ist mit dem Ausgang des zweiten NAND-Gatters NAND 2 verbunden.

Dem Eingang der Aktivierungsschaltung 1 ist das ' Eingangssignal ES zuführbar. Am Ausgang der Aktivierungsschaltung 1 liegt das Aktivierungssignal AKS an. Die Verzögerungseinrichtung 4 ist mit den logischen Gattern NAND1, NAND2 und NOR so verschaltet, dass bei einer steigenden Flanke des Eingangssignals ES das Aktivierungssignal AKS unmittelbar, bei einer fallenden Flanke des Eingangssignals ES jedoch mit einer Verzögerung um die Verzugszeit Δt_{V} dem Eingangssignal ES folgt. Eine Signaländerung am Eingang der Aktivierungsschaltung 1 hat für die Dauer der Haltezeit Δt_{H} keinen Einfluss auf das Aktivierungssignal AKS. Nur eine nach der Haltezeit Δt_{H} auftretende fallende Flanke des Eingangssignals ES führt das Aktivierungssignal AKS in den Aktivzustand zurück.

Die Verzögerungseinrichtung 4 kann beispielsweise als eine Hintereinanderschaltung von Invertern ausgeführt sein. Werden die einzelnen Inverter in komplementärer MOS-Logik (CMOS) aufgebaut, so ist der jeweilige Wert für die Verzugszeit Δt_{V} und der Haltezeit Δt_{H} durch die Wahl von Länge und Weite des Kanals der MOS-Transistoren, insbesondere aus dem Verhältnis von Länge und Weite vorgebbar.

Die Ausgangsschaltung 2 wertet das Eingangssignal ES am Eingang 11 und das Aktivierungssignal AKS am Eingang 12 der Ausgangsschaltung aus. Das Schaltbild einer vorteilhaften Ausführungsform zeigt Figur 4. Der Eingang 11 der Ausgangsschaltung ist mit dem Eingang eines Inverters N1, P1 verbunden, der aus einem ersten Transistor von einem ersten Leitungstyp P1 und einem ersten Transistor von einem zweiten Leitungstyp N1 in komplementärer Schaltungstechnik aufgebaut ist. Der Ausgang des Inverters P1, N1 bildet den Ausgang 13 der Ausgangsschaltung. Zwischen dem ersten Transistor des zweiten Leitungstyps N1 und einem ersten Bezugspotential Vₛₛ ist ein zweiter Transistor des zweiten Leitungstyps N2 geschaltet. Die Kanalseite eines zweiten Transistors vom ersten Leitungstyp P2 ist zwischen einem zweiten Bezugspotential V_{CC} und dem Ausgang 13 der Ausgangsschaltung geschaltet. Die Gate-Anschlüsse des zweiten Transistors vom ersten Leitungstyp P2 und des zweiten Transistors vom zweiten Leitungstyp N2 sind jeweils mit dem Eingang 12 der Ausgangsschaltung verbunden.

Das Eingangssignal ES am Eingang 11 wird nur dann an den Ausgang 13 der Ausgangsschaltung weitergeleitet, wenn das Aktivierungssignal AKS am Eingang 12 einen solchen Zustand aufweist, dass der zweiten Transistor vom zweiten Leitungstyp N2 durchgeschaltet und der zweite Transistor vom ersten Leitungstyp T2 gesperrt ist. Andernfalls nimmt der Ausgang 13 der Ausgangsschaltung unabhängig von einem Signal am Eingang 11 das zweite Bezugspotential V_{CC} an.

Um ein pulsförmiges Ausgangssignal AS mit konstanter Pulsdauer, wie es für viele Anwendungen erwünscht ist, zu erhalten, kann nach der Ausgangsschaltung 2 ein Pulsgenerator 3 vorgesehen werden. In Figur 5 ist ein möglicher Aufbau eines Pulsgenerators 3 dargestellt. Der Pulsgenerator 3 weist ein drittes NAND-Gatter NAND3 auf, an dessen einem Eingang das Ausgangssignal AS vom Ausgang 13 der Ausgangsschaltung 2 unmittelbar und an dessen weiteren Eingang das durch eine Verzögerungsschaltung 5 zeitverzögerte invertierte Ausgangssignal AS anliegt. Am Anschluss 14 liegt das pulsförmige Ausgangssignal AS vor. Der Aufbau der Verzögerungsschaltung 5 kann mit dem Aufbau der Verzögerungseinheit 4 identisch sein.

Dem Fachmann ist klar, dass sowohl vor als auch nach der Aktivierungsschaltung 1 der Ausgangsschaltung 2 und dem Pulsgenerator 3 jeweils ein oder mehrere Inverter vorgesehen werden können, um die Treiberleistung zu erhöhen oder die Schaltungsanordnung von einer negativen Logik auf eine positiven Logik, bei der die steigenden Flanken die interessierenden Flanken sind, anzupassen.

Das erfindungsgemäße Verfahren sowie die erfindungsgemäße Schaltungsanordnung finden insbesondere dort Anwendung wo trotz Störungseinflüssen und Rauschen Taktsignale fehlerfrei ausgewertet werden müssen.

## Patentansprüche

1. Verfahren zur Bearbeitung eines digitalen Eingangssignals (ES) mit den Merkmalen:
- Bei einer ersten Flanke des Eingangssignals (ES) wird von einem Aktivierungssignal (AKS) ein erster Zustand, der sogenannte Passivzustand, angenommen, der mindestens für eine vorgegebene Haltezeit (Δt_{H}) beibehalten wird,
- von dem Aktivierungssignal (AKS) wird bei einer nach der Haltezeit (Δt_{H}) auftretenden von der ersten Flanke verschiedenen zweiten Flanke des Eingangssignals (ES) nach einer Verzögerung mit einer vorgegebenen Verzugszeit (Δtᵥ) ein zweiter Zustand, der sogenannte Aktivzustand angenommen, der von dem ersten Zustand verschieden ist,
- ein digitales Ausgangssignal (AS) wird nur dann aus dem Eingangssignal (ES) abgeleitet, wenn das Aktivierungssignal (AKS) sich im zweiten Zustand befindet.

2. Verfahren nach Anspruch 1 **dadurch gekennzeichnet, dass** die erste Flanke des Eingangssignals (ES) eine steigende Flanke ist.

3. Verfahren nach Anspruch 1 oder 2, **dadurch gekennzeichnet, dass** das Eingangssignal (ES) ein periodisches Taktsignal ist.

4. Verfahren nach einem der vorhergehenden Ansprüche, **dadurch gekennzeichnet, dass** die zeitliche Dauer eines logischen Zustandes des Ausgangssignals (AS) kürzer ist als die zeitliche Dauer zwischen der ersten und der zweiten Flanke des Eingangssignals (ES).

5. Verfahren nach Anspruch 4, **dadurch gekennzeichnet, dass** die zeitliche Dauer dieses Zustandes des Ausgangssignals (AS) konstant ist.

6. Schaltungsanordnung zur Durchführung des Verfahrens nach einem der Ansprüche 1 bis 5, **gekennzeichnet durch**
- eine Aktivierungsschaltung (1), der eingangsseitig das Eingangssignal (ES) zuführbar und ausgangsseitig das Aktivierungssignal (AKS) entnehmbar ist und die einen momentanen Zustand des Aktivierungssignals (AKS) bei einer steigenden Flanke des Eingangssignals,(ES) unmittelbar ändert und dann mindestens für die Dauer der Haltezeit (Δt_{H}) beibehält und bei einer fallenden Flanke nach der Verzögerung mit der Verzugszeit (Δt_{V}) ändert und
- eine Ausgangsschaltung (2) mit einem ersten Eingang (11) für das Eingangssignal (ES), einem zweiten Eingang (12) für das Aktivierungssignal (AKS) und;einem Ausgang (13), die das Eingangssignal (ES) nur bei einem bestimmten Zustand des Aktivierungssignals (AKS) an den Ausgang (13) weiterleitet.

7. Schaltungsanordnung nach Anspruch 6, **dadurch gekennzeichnet, dass** der Ausgangsschaltung (2) ein Pulsgenerator (3) nachgeschaltet ist.

8. Schaltungsanordnung nach Anspruch 6 oder 7, **dadurch gekennzeichnet, dass** die Aktivierungsschaltung eine Verzögerungseinrichtung (4) mit einem nichtinvertierenden Ausgang und einem invertierenden Ausgang einschließt, deren Eingang mit dem Ausgang eines ersten NAND-Gatters (NAND1), einem Eingang eines zweiten NAND-Gatters (NAND2) und einem Eingang eines NOR-Gatters (NOR) verbunden ist und der nichtinvertierende Ausgang mit einem weiteren Ausgang des NOR-Gatters (NOR)und der invertierende Ausgang mit einem weiteren Eingang des zweiten NAND-Gatters (NAND2) verbunden ist, wobei der Ausgang des NOR-Gatters (NOR) dem Ausgang der Aktivierungsschaltung (1) entspricht und der Eingang der Aktivierungsschaltung (1) an einen Eigang des ersten NAND-Gatters (NAND1) angeschlossen ist und ein weiterer Eingang des ersten NAND-Gatters (NAND1) mit dem Ausgang des zweiten NAND-Gatters (NAND2) verbunden ist.

9. Schaltungsanordnung nach Anspruch 6 oder 7, **dadurch gekennzeichnet, dass** die Ausgangsschaltung einen auf Transistoren in komplementärer Schaltungstechnik aufgebauten Inverter (P1, N1) aufweist, an dessen Eingang (11) das digitale Eingangssignal (ES) zuführbar ist und zwischen dessen Ausgang (13) und einem ersten Bezugspotential (V_{SS}) die Kanalseite eines ersten Transistors P2 geschaltet ist und wobei sich zwischen einem zweiten Bezugspotential (V_{CC}) und einem der Transistoren des Inverters (P1, N1) ein zweiter Transistor (N2) von einem anderen Leitungstyp als der erste Transistor (N1) befindet und den Gate-Anschlüssen des ersten (P2) und zweiten (N2) Transistors jeweils das Aktivierungssignal (AKS) zuführbar ist.

10. Schaltungsanordnung nach Anspruch 7, **dadurch gekennzeichnet, dass** der Pulsgenerator 3 ein NAND-Gatter (NAND3) einschließt, an dessen einem Eingang das Ausgangssignal AS unmittelbar und an dessen weiteren Eingang das durch eine Verzögerungsschaltung 5 zeitverzögerte Ausgangssignal AS anliegt.

11. Schaltungsanordnung nach Anspruch 8, **dadurch gekennzeichnet, dass** die Verzögerungseinrichtung (4) eine Hintereinanderschaltung von Invertern aufweist.

12. Schaltungsanordnung nach Anspruch 10, **dadurch gekennzeichnet, dass** die Verzögerungsschaltung (5) eine Hintereinanderschaltung von Invertern aufweist.

## Claims

1. Method for processing a digital input signal (ES), having the following features:
- when a first flank occurs in the input signal (ES), an activation signal (AKS) assumes a first state, the so-called passive state, which is maintained at least for a predetermined holding time (Δt_{H}),
- when a second flank occurs in the input signal (ES) after the holding time (Δt_{H}) and which is not the same as the first flank, the activation signal (AKS) assumes a second state, the so-called active state, after a delay with a predetermined delay time (Δt_{V}), with this second state not being the same as the first state, and
- a digital output signal (AS) is derived from the input signal (ES) only when the activation signal (AKS) is in the second state.

2. Method according to Claim 1, **characterized in that** the first flank of the input signal (ES) is a rising flank.

3. Method according to Claim 1 or 2, **characterized in that** the input signal (ES) is a periodic clock signal.

4. Method according to one of the preceding claims,
**characterized in that** the time duration of one logic state of the output signal (AS) is shorter than the time duration between the first and the second flank of the input signal (ES).

5. Method according to Claim 4, **characterized in that** the time duration of this state of the output signal (AS) is constant.

6. Circuit arrangement for carrying out the method according to one of Claims 1 to 5, **characterized by**:
- an activation circuit (1) to whose input side the input signal (ES) can be supplied and on whose output signal the activation signal (AKS) can be tapped off, and which changes an instantaneous state of the activation signal (AKS) immediately when a rising flank of the input signal (ES) occurs and then maintains this at least for the duration of the holding time (Δt_{H}) and changes this state after the delay with the delay time (Δtᵥ) when a falling flank occurs, and
- an output circuit (2) having a first input (11) for the input signal (ES), a second input (12) for the activation signal (AKS), and an output (13) which passes the input signal (ES) to the output (13) only when the activation signal (AKS) is in a specific state.

7. Circuit arrangement according to Claim 6, **characterized in that** the output circuit (2) is followed by a pulse generator (3).

8. Circuit arrangement according to Claim 6 6 or 7, **characterized in that** the activation circuit includes a delay device (4) with a non-inverting output and an inverting output, whose input is connected to the output of a first NAND gate (NAND1), to one input of a second NAND gate (NAND2) and to one input of a NOR gate (NOR) and the non-inverting output is connected to a further output of the NOR gate (NOR) while the inverting output is connected to a further input of the second NAND gate (NAND2) with the output of the NOR gate (NOR) corresponding to the output of the activation circuit (1), and with the input of the activation circuit (1) being connected to one input of the first NAND gate (NAND1) , and with a further input of the first NAND gate (NAND1) being connected to the output of the second NAND gate (NAND2).

9. Circuit arrangement according to Claim 6 6 or 7, **characterized in that** the output circuit has an inverter (P1, N1) which is formed from transistors using a complementary circuit technique, to whose input (11) the digital input signal (ES) can be supplied, and between whose output (13) and a first reference potential (Vₛₛ) the channel side of a first transistor P2 is connected, and with a second transistor (N2) of a different conductance type to the first transistor (N1) being located between a second reference potential (V_{cc}) and one of the transistors in the inverter (P1, N1), and in which case the activation signal (AKS) can be supplied to the gate connections of both the first transistor (P2) and the second transistor (N2).

10. Circuit arrangement according to Claim 7, **characterized in that** the pulse generator 3 includes a NAND gate (NAND3), to one of whose inputs the output signal AS is applied directly, and to whose further input the output signal AS is applied, delayed by a delay circuit 5.

11. Circuit arrangement according to Claim 8, **characterized in that** the delay device (4) has inverters connected in series.

12. Circuit arrangement according to Claim 10, **characterized in that** the delay circuit (5) has inverters connected in series.

## Revendications

1. Procédé de traitement d'un signal (ES) numérique d'entrée comprenant les caractéristiques :
- pour un premier front du signal (ES) d'entrée, il est pris par un signal (AKS) d'activation un premier état que l'on appelle l'état passif qui est maintenu au moins pendant une durée (Δt_{H}) de maintien donnée à l'avance,
- il est pris par le signal (AKS) d'activation pour un deuxième front du signal (ES) d'entrée différent du premier front, se produisant après la durée (Δt_{H}) de maintien suivant un retard ayant une durée (Δt_{V}) de retard qui est donnée à l'avance, un deuxième état que l'on appelle l'état actif et qui est différent du premier état,
- il est dérivé un signal (AS) numérique de sortie du signal (ES) d'entrée seulement lorsque le signal (AKS) d'activation se trouve dans le deuxième état.

2. Procédé suivant la revendication 1, **caractérisé en ce que** le premier front du signal (ES) d'entrée est un front montant.

3. Procédé selon la revendication 1 ou 2, **caractérisé en ce que** le signal (ES) d'entrée est un signal d'horloge périodique.

4. Procédé selon l'une des revendications précédentes, **caractérisé en ce que** la durée dans le temps d'un état logique du signal (AS) de sortie est plus petite que la durée dans le temps comprise entre le premier et le deuxième front du signal (ES) d'entrée.

5. Procédé selon la revendication 4, **caractérisé en ce que** la durée dans le temps de cet état du signal (AS) de sortie est constante.

6. Circuit de mise en oeuvre du procédé suivant l'une des revendications 1 à 5, **caractérisé par**
- un circuit (1 ) d'activation auquel peut être envoyé du côté de l'entrée le signal (ES) d'entrée et duquel peut être prélevé le signal (AKS) d'activation du côté de la sortie et qui modifie directement un état instantané du signal (AKS) d'activation pour un front montant du signal (ES) d'entrée et le maintient ensuite au moins pendant la durée de maintien (Δt_{H)} et le modifie pour un front descendant après le retard ayant la durée (Δtᵥ) de retard, et
- un circuit (2) de sortie, comprenant une première entrée (11) pour le signal (ES) d'entrée, une deuxième entrée (12) pour le signal (AKS) d'activation et une sortie (13), qui achemine le signal (ES) d'entrée vers la sortie (13), seulement pour un certain état du signal (AKS) d'activation.

7. Circuit selon la revendication 6, **caractérisé en ce qu'**un générateur (3) d'impulsion est monté en aval du circuit (2) de sortie.

8. Circuit selon la revendication 6 ou 7, **caractérisé en ce que** le circuit d'activation a un dispositif (4) de retard comprenant une sortie non inverseuse et une sortie inverseuse dont l'entrée est reliée à la sortie d'une première porte (NAND1) NON ET à une entrée d'une deuxième porte (NAND2) NON ET et à une entrée d'une porte (NOR) NON OU, et l'entrée non inverseuse est reliée à une autre sortie de la porte (NOR) NON OU, et la sortie inverseuse est reliée à une autre entrée de la deuxième porte (NAND2) NON ET, la sortie de la porte (NOR) NON OU correspondant à la sortie du circuit (1) d'activation et l'entrée du circuit (1) d'activation étant raccordée à une entrée de la première porte (NAND1) NON ET et une autre entrée de la première porte (NAND1) NON ET étant reliée à la sortie de la deuxième porte (NAND2) NON ET.

9. Circuit selon la revendication 6 ou 7, **caractérisé en ce que** le circuit de sortie comprend un inverseur (P1, N1) constitué de transistors suivant la technique de circuits complémentaires à l'entrée (11 ) duquel le signal (ES) numérique d'entrée peut être envoyé, et entre la sortie (13) duquel et un premier potentiel (Vₛₛ) de référence est monté le côté canal d'un premier transistor (P2) et il y a entre un deuxième potentiel (V_{cc}) de référence et l'un des transistors de l'inverseur (P1, N1 ) un deuxième transistor (N2) d'un autre type de conductivité que celui du premier transistor (N1) et il peut être envoyé respectivement le signal (AKS) d'activation aux bornes de grille du premier (P2) et du deuxième (N2) transistor.

10. Circuit selon la revendication 7, **caractérisé en ce que** le générateur (3) d'impulsion comprend une porte (NAND3) NON ET à l'une des entrées de laquelle le signal (AS) de sortie est appliqué directement et à l'autre entrée de laquelle le signal (AS) de sortie est appliqué avec retard dans le temps par le circuit (5) de retard.

11. Circuit selon la revendication 8, **caractérisé en ce que** le dispositif (4) de retard comprend un circuit série d'inverseurs.

12. Circuit selon la revendication 10, **caractérisé en ce que** le circuit (5) de retard comprend un circuit série d'inverseurs.
